Europäisches Patentamt

European Patent Office

Office européen des brevets

(19)

(11) **EP 0 682 411 B1**

(12) **FASCICULE DE BREVET EUROPEEN**

(45) Date de publication et mention
de la délivrance du brevet:
**06.10.1999 Bulletin 1999/40**

(51) Int Cl.⁶: **H03K 23/66**

(21) Numéro de dépôt: **95201105.4**

(22) Date de dépôt: **28.04.1995**

(54) **Diviseur de fréquence, synthétiseur de fréquence comportant un tel diviseur et radiotéléphone comportant un tel synthétiseur**

Frequenzteiler, Frequenzsynthesizer mit einem solchen Teiler und Funktelefon mit einem solchen Synthesizer

Frequency divider, frequency synthesizer with such a divider and radio telephone with such a synthesizer

(84) Etats contractants désignés:
**DE FR GB**

(30) Priorité: **04.05.1994 FR 9405483**

(43) Date de publication de la demande:
**15.11.1995 Bulletin 1995/46**

(73) Titulaires:
- **PHILIPS COMPOSANTS ET SEMICONDUCTEURS**
  **92150 Suresnes (FR)**
  Etats contractants désignés:
  **FR**
- **Koninklijke Philips Electronics N.V.**
  **5621 BA Eindhoven (NL)**
  Etats contractants désignés:
  **DE GB**

(72) Inventeur: **Dufour, Yves**
**F-75008 Paris (FR)**

(74) Mandataire: **Charpail, François et al**
**Société Civile S.P.I.D.**
**156, Boulevard Haussmann**
**75008 Paris (FR)**

(56) Documents cités:
**EP-A- 0 517 335        DE-A- 4 008 385**
**FR-A- 2 666 707        US-A- 4 421 952**
**US-A- 4 575 867**

## Description

La présente invention concerne un circuit diviseur de fréquence programmable comportant p cellules de division de fréquence disposées en cascade, chacune de ces cellules représentant un rang i de division et étant susceptible d'être commutée entre un mode de division par deux, dit mode normal, et un mode de division par trois, dit mode programmé, une cellule de rang i quelconque comportant:

- une première entrée pour un signal de fréquence d'entrée,
- une première sortie pour un signal de fréquence de sortie à appliquer à la première entrée de la cellule de rang supérieur,
- une deuxième entrée pour un signal d'autorisation du mode programmé,
- une troisième entrée pour un signal de programmation,
- une deuxième sortie pour un signal engendré à partir du signal d'autorisation reçu sur sa deuxième entrée et appliqué en tant que signal d'autorisation à la deuxième entrée de la cellule de rang inférieur.

La présente invention a d'importantes applications notamment pour la réalisation de synthétiseur de fréquences dans le domaine des transmissions radioélectriques.

Un tel circuit diviseur est décrit dans la demande de brevet européen n°0517335 déposée par la demanderesse le 4 juin 1992. Chaque cellule de ce circuit effectue une division du signal de fréquence d'entrée, par deux en mode normal, et par trois en mode programmé, de telle sorte que le rapport de division minimal de ce circuit est égal à $R_{min} = 2^p$, et que son rapport de division maximal est égal à $R_{max} = 2^{p+1} - 1$.

Un même circuit ne permet donc pas d'obtenir des rapports de division et très faibles et très élevés.

Le but de la présente invention est de proposer un circuit qui apporte une solution à ce problème.

Pour cela un circuit diviseur programmable selon l'invention et tel que décrit dans le paragraphe introductif est caractérisé en ce qu'au moins une cellule comporte une entrée supplémentaire permettant de mettre la seconde sortie de ladite cellule à un niveau actif de façon à désactiver ladite cellule du point de vue de la division.

Dans un mode de réalisation particulièrement avantageux, un circuit diviseur selon l'invention comporte des moyens pour:

- désactiver les cellules de rang p à p-q,
- sélectionner un signal de sortie dudit circuit diviseur, de fréquence égale à celle du signal de fréquence de sortie de la cellule de rang p-q-1.

Ce mode de réalisation présente l'avantage d'être particulièrement simple, notamment lorsque le circuit diviseur de fréquence comporte alors, en plus, des moyens pour prélever comme signal de sortie, le signal délivré sur la deuxième sortie de la première cellule.

En effet, le signal délivré sur la deuxième sortie de la première cellule est à la même fréquence que le signal de fréquence de sortie de la dernière cellule active. Le choix d'une telle sortie présente donc l'avantage d'être indépendant du nombre de cellules désactivées. De plus, le signal délivré sur cette sortie étant dérivé du signal de fréquence d'entrée du circuit, il présente un bruit de phase très faible par rapport à celui du signal de fréquence de sortie de la dernière cellule active.

Le signal de sortie ainsi obtenu présente un rapport cyclique faible, et un circuit diviseur selon l'invention comporte donc avantageusement des moyens pour augmenter ce rapport cyclique.

L'invention concerne également un synthétiseur de fréquences qui comporte un circuit diviseur de fréquences programmable tel que décrit dans les paragraphes précédents, et un radiotéléphone dont soit le circuit d'émission soit le circuit de réception contient un tel synthétiseur.

D'autres particularités, détails et avantages de la présente invention seront mis en évidence dans la description qui va suivre en regard des dessins annexés qui sont donnés à titre d'exemple non limitatif, dans lesquels:

- la figure 1 représente le schéma classique d'une cellule de division par deux ou trois,
- la figure 2 représente un chronogramme expliquant le fonctionnement en mode normal d'une cellule telle que représentée sur la figure 1,
- la figure 3 représente un chronogramme expliquant le fonctionnement en mode programmé d'une cellule telle que représentée sur la figure 1,
- la figure 4 représente, pour un premier mode de réalisation, une cellule selon l'invention susceptible d'être désactivée,
- la figure 5 représente, pour ledit premier mode de réalisation, une bascule de type D destinée à être intégrée dans une cellule telle que représentée sur la figure 4,
- la figure 6 représente ledit premier mode de réalisation d'un circuit diviseur selon l'invention dont le rapport de division varie entre 2 et 31,
- la figure 7 représente un chronogramme explicitant le fonctionnement d'un circuit diviseur tel que représenté sur la figure 6, pour une division par 12,
- la figure 8 représente un second mode de réalisation d'un circuit diviseur selon l'invention dont le rapport de division varie entre 2 et 31,
- la figure 9 représente un synthétiseur de fréquence utilisant un circuit diviseur de fréquence programmable selon l'invention,
- la figure 10 représente un radiotéléphone dont le circuit d'émission et de réception utilise un synthétiseur de fréquence tel que représenté sur la figure 9.

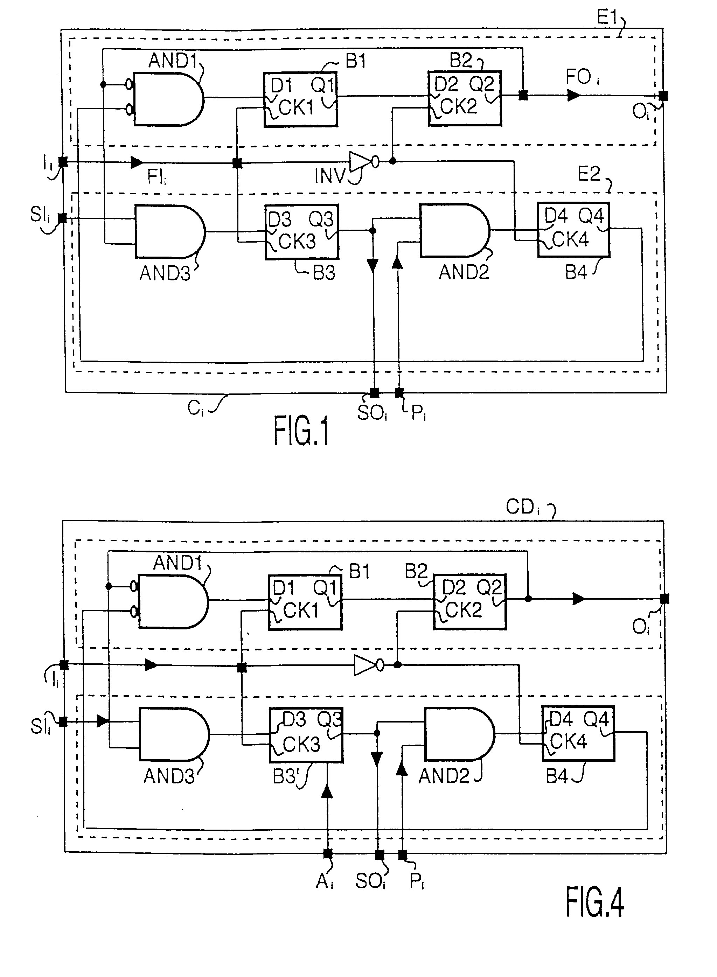

D'après la figure 1, une cellule $C_i$ de division par deux ou trois, de rang i, comporte un étage E1 de division par deux d'un signal de fréquence d'entrée $FI_i$ et un étage E2 d'avalement pour une division par trois dudit signal $FI_i$.

L'étage E1 comporte deux bascules B1 et B2 de type D, montées en cascade. L'entrée d'horloge CK1 de la bascule B1 constitue la première entrée $I_i$ de la cellule et reçoit le signal de fréquence d'entrée $FI_i$. L'entrée d'horloge CK2 de la bascule B2 reçoit le signal de fréquence d'entrée inversé $\overline{FI_i}$ issu d'un inverseur INV. La sortie Q2 de la bascule B2 constitue la première sortie $O_i$ de la cellule et est rebouclée, après inversion, sur une première entrée d'une porte "ET", notée AND1, dont la sortie est connectée à l'entrée de données D1 de la bascule B1.

L'étage E2 comporte deux bascules B3 et B4 de type D. L'entrée d'horloge CK3 de la bascule B3 reçoit le signal de fréquence d'entrée $FI_i$, et l'entrée d'horloge CK4 de la bascule B4 reçoit le signal de fréquence d'entrée inversé $\overline{FI_i}$ issu de l'inverseur INV. La sortie Q3 de la bascule B3, qui constitue la deuxième sortie $SO_i$ de la cellule, est couplée à l'entrée de données D4 de la bascule B4 par l'intermédiaire d'une porte "ET", notée AND2, dont une seconde entrée constitue l'entrée $P_i$ de la cellule. La sortie Q4 de la bascule B4 est rebouclée, après inversion, sur une seconde entrée de la porte AND1. L'entrée de données D3 de la bascule B3 est connectée à la sortie d'une porte "ET", notée AND3, dont une première entrée constitue la deuxième entrée $SI_i$ de la cellule et dont une seconde entrée reçoit le signal de fréquence de sortie $FO_i$ de la cellule.

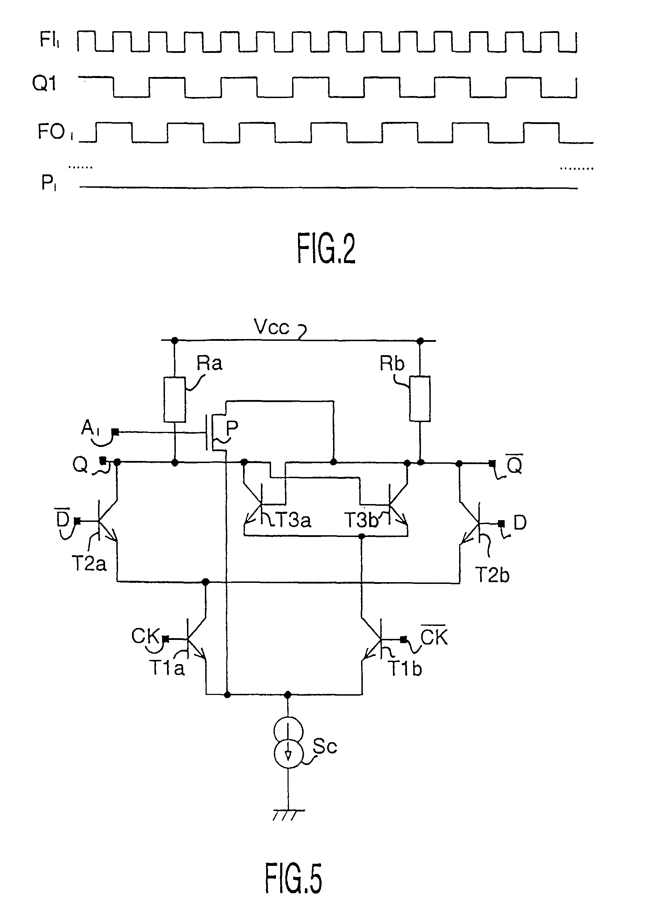

Le fonctionnement de cette cellule en mode normal est explicité en liaison avec le chronogramme de la figure 2. Dans ce cas, l'entrée de programmation Pi est au niveau 0, ce qui a pour effet de verrouiller la porte AND2 de telle sorte que la seconde entrée de la porte AND1 est toujours à 1. L'étage E2 d'avalement n'influe donc pas sur le comportement de la cellule.

En supposant qu'à l'instant initial la sortie $O_i$ de la cellule $C_i$ soit au niveau 0, la première entrée de la porte AND1 est à 1, de telle sorte que l'entrée de données D1 de la bascule B1 est également à 1. Sur un front montant de son signal d'horloge $FI_i$, la sortie Q1 de la bascule B1 et l'entrée D2 de la bascule B2 passent donc à 1. Et sur le front descendant suivant du signal FIi, la sortie Q2 de la bascule B2 et donc la sortie $O_i$ de la cellule $C_i$ passent à 1. Sur le front montant suivant du signal FIi, la sortie de la bascule B1 repasse donc à zéro, tandis que la sortie Oi de la bascule B2 ne repasse à zéro que sur le front descendant suivant. Le signal de fréquence de sortie $FO_i$ ainsi obtenu sur la sortie $O_i$ de la cellule correspond donc bien à une fréquence moitié de son signal de fréquence d'entrée $FI_i$.

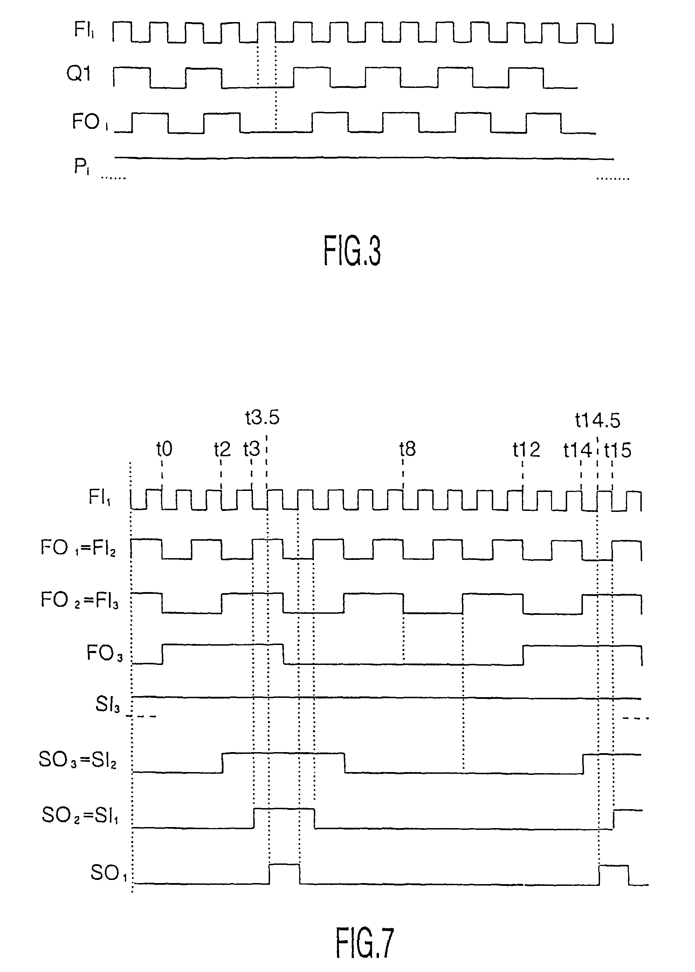

Le chronogramme de la figure 3 explicite le fonctionnement de la cellule de la figure 1 en mode programmé. L'entrée de programmation $P_i$ est alors au niveau 1, ce qui a pour effet de déverrouiller la porte AND2 lorsque la deuxième sortie $SO_i$ de la cellule passe à 1, de telle sorte que la seconde entrée de la porte AND1 est alors à 0, ce qui permet "l'avalement" d'une période supplémentaire du signal de fréquence d'entrée par rapport au mode normal de division par deux.

La figure 4 représente schématiquement une cellule $CD_i$ susceptible d'être désactivée. Cette cellule est similaire à celle représentée sur la figure 1, mais la bascule B3 est maintenant remplacée par une bascule B3' qui comporte une entrée supplémentaire $A_i$.

Cette bascule B3' est représentée sur la figure 5, pour un premier mode de réalisation. Il s'agit d'une bascule de type D classique, en logique ECL, composée de trois paires différentielles de transistors, T1a et T1b, T2a et T2b, T3a et T3b. Les bases des transistors T1a et T1b sont respectivement reliées à l'entrée d'horloge CK de la bascule B3' et à son inverse $\overline{CK}$, et les bases des transistors T2b et T2a sont respectivement reliées à l'entrée de données D de la bascule B3' et à son inverse $\overline{D}$. Les bases des transistors T3b et T3a constituent respectivement la sortie Q de la bascule et son inverse $\overline{Q}$, et sont respectivement connectées d'une part aux collecteurs des transistors T2a et T3a ainsi que, par l'intermédiaire d'une résistance Ra, à une borne de tension d'alimentation Vcc, et d'autre part aux collecteurs des transistors T2b et T3b ainsi que, par l'intermédiaire d'une résistance Rb, à ladite borne de tension d'alimentation Vcc. Les émetteurs des transistors T3a et T3b sont reliés au collecteur du transistor T1b, et les émetteurs des transistors T2a et T2b sont reliés au collecteur du transistor T1a. Les émetteurs des transistors T1a et T1b sont connectés à une source de courant Sc.

Conformément à l'invention, la bascule B3' comporte en outre un transistor PMOS, noté P, dont la grille est connectée à l'entrée $A_i$ de la bascule, dont la source est reliée à la sortie inverseuse $\overline{Q}$ de la bascule, et dont le drain est relié aux émetteurs des transistors T1a et T1b.

Ainsi, lorsque l'entrée $A_i$ est au niveau 1, le transistor P se comporte comme un circuit ouvert, et le fonctionnement de la bascule B3' est celui d'une bascule classique, recopiant sur sa sortie Q la valeur présente sur son entrée D pour un front montant du signal d'horloge CK.

Lorsqu'au contraire, l'entrée $A_i$ est au niveau 0, le transistor P se comporte comme un court-circuit, le transistor T3a est bloqué et la sortie Q est au niveau 1 quel que soit le niveau du signal sur l'entrée D de la bascule. La deuxième sortie $SO_i$ de la cellule est donc continûment à 1, ce qui permet de désactiver ladite cellule de façon à ce qu'elle n'intervienne pas dans la division. Il est ainsi possible d'empêcher toute action sur la division de la part de la cellule désactivée et de toutes les cellules de rang supérieur.

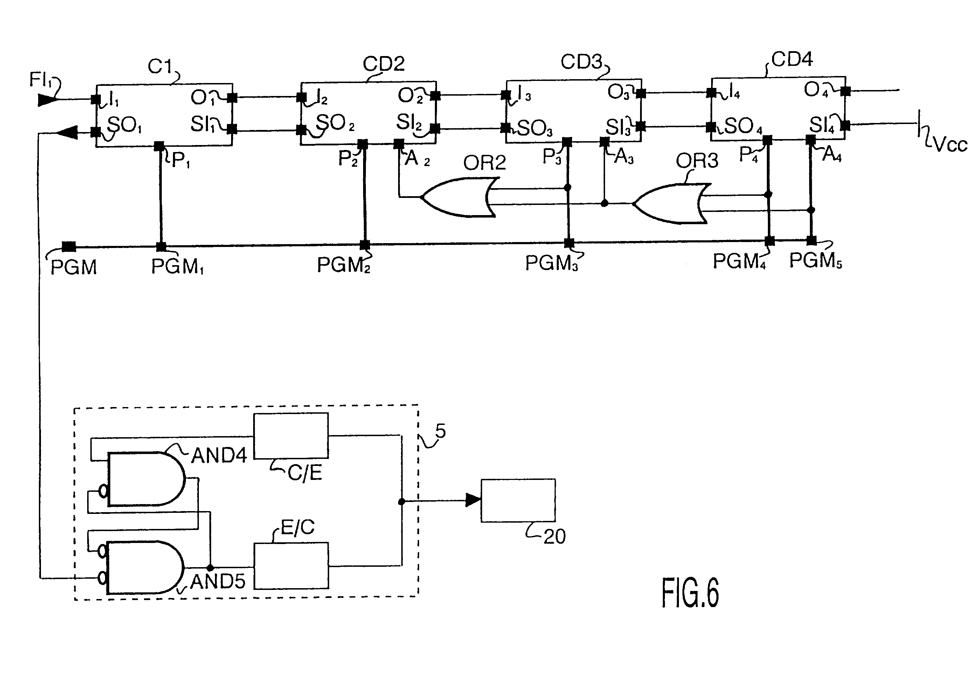

La figure 6 représente un circuit diviseur selon l'invention, dont le rapport de division, qui varie entre 2 et 31, est fixé par un mot de programmation PGM de cinq éléments binaires notés $PGM_i$ (avec i variant de 1 à 5). Un tel diviseur comporte en cascade une cellule classique C1 suivie de trois cellules susceptibles d'être désactivées CD2, CD3 et CD4, de telle sorte que la première sortie $O_i$ d'une cellule de rang i est reliée à la première entrée $I_{i+1}$ de la cellule de rang i+1, et que la deuxième sortie $SO_i$ d'une cellule de rang i est reliée à la deuxième entrée $SI_{i-1}$ de la cellule de rang i-1. La première entrée de la cellule C1 reçoit le signal à diviser $FI_1$, et sa seconde sortie $SO_1$, qui délivre un signal de fréquence égale à celle du signal de fréquence de sortie de la dernière cellule active, constitue la sortie du diviseur. La deuxième entrée de la dernière cellule CD4 est reliée à la borne de tension d'alimentation Vcc de façon à être continûment au niveau logique 1. Enfin, la sortie du diviseur est reliée à un circuit 5 permettant d'augmenter le rapport cyclique du signal de sortie.

Les cellules CD2, CD3 et CD4 comportent chacune une entrée supplémentaire respectivement notée A2, A3 et A4. Le cinquième élément binaire $PGM_5$ du mot de programmation est porté sur l'entrée A4 de la cellule CD4, tandis que les quatrième, troisième, deuxième et premier éléments binaires $PGM_4$, $PGM_3$, $PGM_2$ et $PGM_1$ sont respectivement portés sur les entrées de programmation P4, P3, P2 et P1 des cellules CD4, CD3, CD2 et C1. D'autre part, les entrées A4 et P4 de la cellule CD4 constituent les deux entrées d'une porte "OU" notée OR1 dont la sortie est reliée à l'entrée A3 de la cellule CD3. De même, les entrées A3 et P3 de la cellule CD3 constituent les deux entrées d'une porte "OU" notée OR2 dont la sortie est reliée à l'entrée A2 de la cellule CD2.

Ainsi, si l'on souhaite réaliser une division par un nombre inférieur à 16 par exemple, il faut désactiver la dernière cellule CD4. Pour cela, son entrée A4 doit être portée à 0, et l'élément binaire de programmation $PGM_5$ doit donc être fixé à 0. La deuxième entrée $SI_3$ de la cellule CD3 est ainsi continûment portée au niveau logique 1.

Si le nombre diviseur recherché est compris entre 8 et 15, les entrées A3 et A2 des cellules CD3 et CD2 doivent alors être portée à 1. Pour cela l'élément binaire de programmation $PGM_4$ doit être fixé à 1 de telle sorte que la sortie de la porte OR3 soit à 1. Les autres éléments binaires de programmation sont ensuite choisis en fonction du nombre diviseur recherché. En effet, comme cela a été démontré dans le document précité, si l'on cherche à obtenir une période à la sortie d'une cellule de rang p, il faut disposer de $2^p+N$ périodes à l'entrée de la première cellule (où $N = PGM_1 + 2.PGM_2 +...+ 2^p.PGM_{p+1}$). Par exemple pour obtenir un nombre diviseur égal à 12, il faudra choisir $PGM_5=0$, $PGM_4=1$, $PGM_3=1$ et $PGM_2=0$, $PGM_1=0$.

Si le nombre diviseur recherché est inférieur à 8, la cellule CD3 doit être désactivée, et PGM3 doit donc être égal à 0. La sortie de la porte OR2 est alors égale à 0, et donc le deuxième signal d'entrée de la cellule CD2 est continûment égal à 1.

De même si le nombre diviseur recherché est inférieur à 4, la cellule CD2 doit également être désactivée, et donc l'élément binaire PGM2 doit être choisi égal à 0.

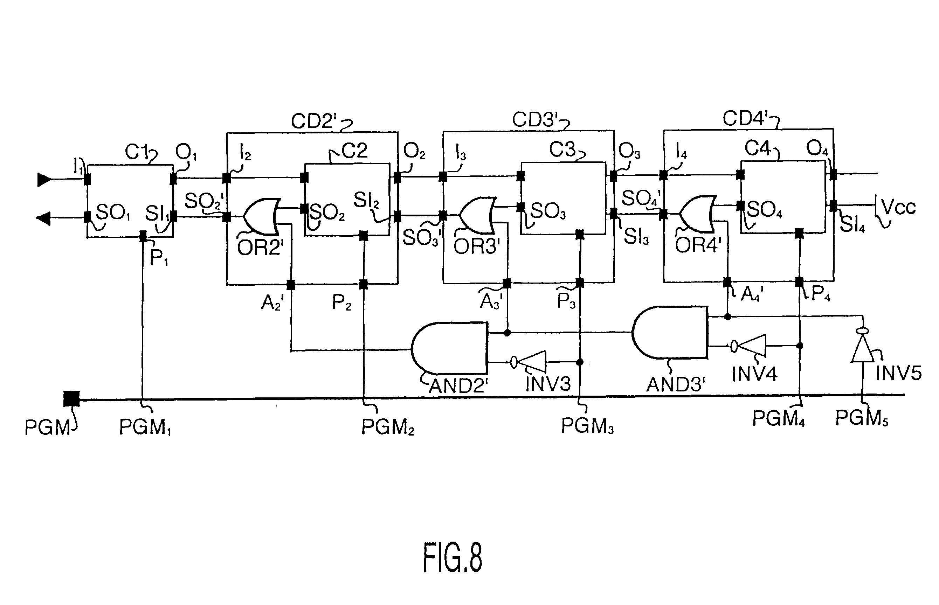

Le chronogramme de la figure 7 représente l'état des signaux d'entrée et de sortie des différentes cellules d'un diviseur tel que représenté sur la figure 6, dans le cas d'une division par 12.

Dans ce cas, comme cela a été expliqué plus haut, la cellule CD4 est désactivée, la cellule CD3 réalise une division par 3, et les cellules CD2 et C1 une division par 2. Entre les instants t0 et t12, on observe donc 12 périodes du signal de fréquence d'entrée $FI_1$, 6 périodes du signal $FI_2$, 3 périodes du signal $FI_3$ et 1 période du signal de fréquence de sortie $FO_3$, la deuxième du période du signal $FI_3$, comprise entre les instants t4 et t8 étant "avalée" par la cellule CD3 de façon à effectuer une division par 3. Le signal d'autorisation reçu sur la deuxième entrée $SI_3$ de la cellule CD3 est continûment au niveau 1; le signal d'autorisation reçu sur la deuxième entrée $SI_2$ de la cellule CD2 présente une période comprise entre les instants t2 et t14, égale à la période du signal de fréquence de sortie $FO_3$, et son rapport cyclique est égal à 1/3; le signal d'autorisation reçu sur la deuxième entrée $SI_1$ de la cellule C1 présente une période comprise entre les instants t3 et t15, égale à la période du signal de fréquence de sortie $FO_3$, et son rapport cyclique est égal à 1/6; enfin le signal délivré sur la deuxième sortie $SO_1$ de la première cellule C1 présente une période comprise entre les instants t3.5 et t14.5, égale à la période du signal de fréquence de sortie $FO_3$, et son rapport cyclique est égal à 1/12.

Pour certaines applications d'un tel circuit diviseur, et notamment lorsqu'il est utilisé dans un synthétiseur de fréquences basé sur la logique CMOS, il est nécessaire d'augmenter ce rapport cyclique qui est d'autant plus faible que la fréquence d'entrée est élevée.

Pour cela, la sortie du diviseur est reliée à un circuit 5 permettant d'augmenter le rapport cyclique du signal de sortie. Ce circuit est constitué à partir d'une bascule de type RS comportant deux portes "ET" notées AND4 et AND5, les première et seconde entrées de la porte AND5 recevant respectivement l'inverse du signal de sortie $SO_1$ du diviseur et l'inverse du signal de sortie de la porte AND4, tandis que les première et seconde entrées de la porte AND4 reçoivent respectivement l'inverse de la sortie de la porte AND5 et la sortie d'un convertisseur CMOS/ECL, noté C/E, lui-même relié à une première entrée d'un comparateur de phase 20 d'un synthétiseur de fréquences. La sortie de la porte AND5 est en outre reliée à l'entrée d'un convertisseur ECL/CMOS, noté E/C, dont la sortie est connectée à ladite entrée du comparateur de phase 20.

Ainsi, la sortie de la porte AND5 passe à zéro sur un front montant du signal de sortie du diviseur, et elle y reste après la disparition de ce signal de sortie jusqu'à ce que la sortie de la porte AND4 passe elle aussi à zéro après la transformation ECL/CMOS/ECL. Le comparateur aura alors reçu le front haut du signal de sortie du diviseur.

La figure 8 donne un autre mode de réalisation d'un circuit diviseur selon l'invention. Les cellules susceptibles d'être désactivées sont différentes de celles de la figure 6, et sont notées CDi'.

Chaque cellule CDi' est composée d'une cellule classique Ci telle que représentée sur la figure 1, la sortie $SO_i$ de cette cellule étant reliée à une première entrée d'une porte "OU" notée $OR_i'$ dont la sortie constitue la sortie $SO_i'$ de la cellule $CD_i'$. L'autre entrée de la porte $OR_i'$ est reliée à une entrée supplémentaire Ai' de la cellule CDi'. Les autres entrées $I_i$, $SI_i$ et $P_i$ de la cellule Ci constituent les entrées les première, seconde et troisième entrées de la cellule CDi'.

De même que sur la figure 6, le rapport de division du circuit diviseur varie entre 2 et 31, et il est fixé par un mot de programmation PGM de cinq éléments binaires notés $PGM_i$ (avec i variant de 1 à 5). Un tel diviseur comporte en cascade une cellule classique C1 suivie de trois cellules susceptibles d'être désactivées CD2', CD3' et CD4', de telle sorte que la première sortie $O_i$ d'une cellule de rang i est reliée à la première entrée $I_{i+1}$ de la cellule de rang i+1, et que la deuxième sortie $SO_i'$ d'une cellule de rang i est reliée à la deuxième entrée $SI_{i-1}$ de la cellule de rang i-1. La première entrée de la cellule C1 reçoit le signal à diviser $FI_1$, et sa seconde sortie $SO_1$, qui délivre un signal de fréquence égale à celle du signal de fréquence de sortie de la dernière cellule active, constitue la sortie du diviseur. La deuxième entrée de la dernière cellule CD4' est reliée à la borne de tension d'alimentation Vcc de façon à être continûment au niveau logique 1.

Les cellules CD2', CD3' et CD4' comportent chacune une entrée supplémentaire respectivement notée $A_2'$, $A_3'$ et $A_4'$. Le cinquième élément binaire $PGM_5$ du mot de programmation est porté, après inversion par un inverseur INV5, sur l'entrée supplémentaire $A_4'$ de la cellule CD4' d'une part, et sur une première entrée d'une porte "ET" notée AND3' d'autre part. Les quatrième et troisième éléments binaires $PGM_4$ et $PGM_3$ sont respectivement portés sur les entrées de programmation $P_4$ et $P_3$ d'une part et, après inversion par un inverseur INV4 et INV3 respectivement, sur une deuxième entrée de la porte AND3' et sur une première entrée d'une porte "ET" notée AND2' respectivement. Les deuxième et premier éléments binaires $PGM_2$ et $PGM_1$ sont respectivement portés sur les entrées de programmation $P_2$ et $P_1$ des cellules CD2 et C1. La sortie de la porte AND3' est reliée d'une part à l'entrée supplémentaire $A_3'$ de la cellule CD3' et d'autre part à une seconde entrée de la porte AND2'. De même, la sortie de la porte AND2' est reliée à l'entrée supplémentaire $A_2'$ de la cellule CD2'.

Ainsi, la cellule CD4' est désactivée pour la valeur PGM5=0, puisque dans ce cas la sortie S04' de la cellule est portée continûment à 1. De même, la cellule CD3' est désactivée pour les valeurs PGM5=PGM4=0 et la cellule CD2' est désactivée pour les valeurs PGM5=PGM4=PGM3=0.

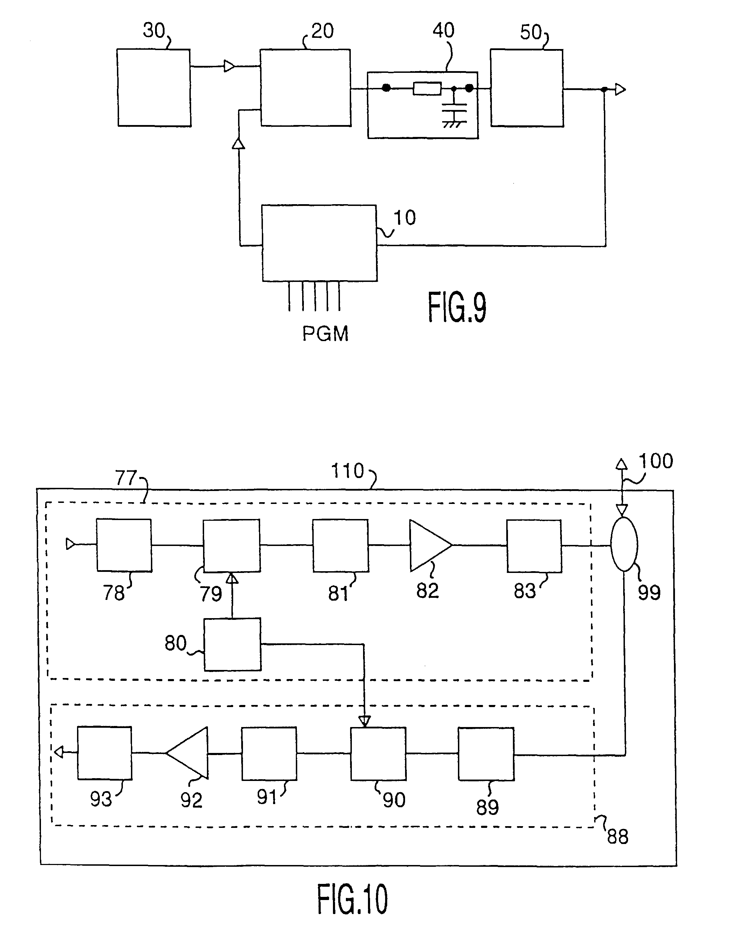

La figure 9 représente un synthétiseur de fréquence utilisant un circuit diviseur tel que décrit précédemment. Ce synthétiseur de fréquence comporte un circuit diviseur de fréquence 10 dont la sortie est reliée à une première entrée d'un circuit comparateur de phase 20. Une seconde entrée de ce circuit comparateur de phase 20 reçoit une fréquence émise par un oscillateur à quartz 30. Ce comparateur de phase 20 est relié à un circuit intégrateur 40 dont la sortie commande un oscillateur variable 50. La sortie de cet oscillateur variable est reliée à l'entrée du circuit diviseur 10 et constitue la sortie du synthétiseur de fréquence.

La figure 10 représente schématiquement un radiotéléphone 110 comportant un circuit d'émission 77 et un circuit de réception 88 reliés par l'intermédiaire d'un circulateur 99 à une antenne d'émission/réception 100 et utilisant un synthétiseur de fréquence tel que représenté sur la figure 8.

Le circuit d'émission 77 comporte un modulateur 78 délivrant un signal de fréquence intermédiaire fi qui est porté sur une première entrée d'un circuit mélangeur 79 dont une seconde entrée reçoit un signal de sortie d'un synthétiseur de fréquences 80 tel que celui qui a été décrit sur la figure 8. La sortie de ce circuit mélangeur 79 est reliée à un filtre 81 lui-même relié à un amplificateur 82. La sortie de cet amplificateur 82 passe ensuite dans un second filtre 83 avant d'être délivrée sur le circulateur 99.

Le circuit de réception 88 comporte un filtre 89 connecté à la sortie du circulateur 99. La sortie de ce filtre 89 est reliée à une première entrée d'un circuit mélangeur 90 dont une seconde entrée reçoit un signal de sortie du synthétiseur de fréquences 80. La sortie de ce circuit mélangeur 90 est relié à un filtre 91 lui-même relié à un amplificateur 92 à contrôle automatique de gain. La sortie de cet amplificateur 92, enfin, est connectée à un démodulateur 93.

Il va de soi que des modifications peuvent être apportées aux modes de réalisation qui viennent d'être décrit.

Deux modes de réalisation différents de circuit diviseur ont été décrits, mais d'autres moyens logiques peuvent conduire au même résultat.

De plus, on aurait également pu choisir de désactiver d'autres cellules que les cellules de fin de chaîne. Il est par exemple possible de désactiver les cellules de début de chaîne, et de déterminer dans chaque cas l'entrée à utiliser.

De même, on aurait pu choisir de sélectionner une autre sortie du diviseur que la deuxième sortie de la première cellule de la chaîne.

Enfin, le synthétiseur de fréquences de la figure 9 et le radiotéléphone de la figure 10 sont représentés schématiquement de façon à faire apparaître les principaux blocs fonctionnels qui les composent. Leur réalisation peut présenter de nombreuses variantes qui sont connues de l'homme du métier et n'ont donc pas à être décrites ici.

## Revendications

1. Circuit diviseur de fréquence programmable comportant p cellules de division de fréquence disposées en cascade, chacune de ces cellules représentant un rang i de division et étant susceptible d'être commutée entre un mode de division par deux, dit mode normal, et un mode de division par trois, dit mode programmé, une cellule de rang i quelconque comportant:

   - une première entrée ($I_i$) pour un signal de fréquence d'entrée ($FI_i$),
   - une première sortie ($O_i$) pour un signal de fréquence de sortie ($FO_i$) à appliquer à la première entrée ($I_{i+1}$) de la cellule de rang supérieur (i+1).
   - une deuxième entrée ($SI_i$) pour un signal d'autorisation du mode programmé,
   - une troisième entrée ($P_i$) pour un signal de programmation,
   - une deuxième sortie ($SO_i$) pour un signal engendré à partir du signal d'autorisation reçu sur sa deuxième entrée ($SI_i$) et appliqué en tant que signal d'autorisation à la deuxième entrée ($SI_{i-1}$) de la cellule de rang inférieur (i-1), caractérisé en ce qu'au moins une cellule comporte une entrée supplémentaire ($A_i$, $A_i'$) permettant de mettre la seconde sortie ($SO_i$) de ladite cellule à un niveau actif de façon à désactiver ladite cellule du point de vue de la division.

2. Circuit diviseur selon la revendication 1, caractérisé en ce qu'il comporte des moyens pour:

   - désactiver les cellules de rang p à p-q,
   - sélectionner un signal de sortie dudit circuit diviseur, de fréquence égale à celle du signal de fréquence de sortie ($FO_{p-q-1}$) de la cellule de rang p-q-1.

3. Circuit diviseur selon la revendication 2, caractérisé en ce que pour désactiver une cellule quelconque de rang i, il comporte des moyens permettant de fournir sur la deuxième entrée ($SI_{i-1}$) de la cellule de rang inférieur (i-1) un signal d'autorisation continûment actif.

4. Circuit diviseur selon la revendication 3, caractérisé en ce que chaque cellule de rang i comporte:

   - un étage de division par deux du signal de fréquence d'entrée ($FI_i$) de la cellule, constitué à partir d'une première (B1) et d'une seconde (B2) bascule de type D cadencées en inverse l'une de l'autre par ledit signal de fréquence d'entré ($FI_i$), la sortie de la deuxième bascule (B2), qui constitue la sortie ($O_i$) de la cellule, étant rebouclée sur l'entrée de données de la première bascule (B1),
   - un étage d'avalement constitué à partir d'une troisième (B3) et d'une quatrième bascule (B4) de type D, la sortie de la quatrième bascule (B4) permettant de forcer l'entrée de données de la première bascule (B1), en vue d'un avalement, pour une division par trois dudit signal de fréquence d'entrée ($FI_i$) lorsque les signaux de programmation et d'autorisation de la cellule sont actifs,
   - et la troisième bascule (B3) comportant, lorsque la cellule est susceptible d'être désactivée, une entrée supplémentaire ($A_i$) couplée à l'électrode de commande d'un transistor (P), et qui permet lorsque le signal qu'elle reçoit, dit signal d'activation, n'est plus actif, de porter à un niveau continûment actif la sortie de cette troisième bascule (B3) qui constitue par ailleurs la deuxième sortie ($SO_i$) de la cellule.

5. Circuit diviseur selon la revendication 4, caractérisé en ce que ledit signal d'activation est obtenu par une opération "ET" logique entre les signaux de programmation et d'activation de la cellule de rang supérieur i+1.

6. Circuit diviseur selon l'une des revendications 2 à 5, caractérisé en ce qu'il comporte des moyens pour prélever comme signal de sortie, le signal délivré sur la deuxième sortie ($SO_1$) de la première cellule.

7. Circuit diviseur selon la revendication 6, caractérisé en ce qu'il comporte des moyens pour augmenter le rapport cyclique dudit signal de sortie.

8. Synthétiseur de fréquence caractérisé en ce qu'il comporte un circuit diviseur de fréquence programmable selon l'une des revendications 1 à 7.

9. Radiotéléphone dont soit le circuit d'émission soit le circuit de réception comporte un synthétiseur de fréquence selon la revendication 8.

## Patentansprüche

1. Programmierbare Frequenzteilerschaltung mit p Frequenzteilerzellen, die in Kaskadenschaltung angeordnet sind, wobei jede dieser Zellen eine Rangstufe i der Teilung darstellt und geeignet ist, zwischen einem Modus der Teilung durch zwei, als normaler Modus bezeichnet, und einem Modus der Teilung durch drei, als programmierter Modus bezeichnet, umgeschaltet zu werden, und wobei jede Zelle der Rangstufe i folgendes umfaßt:

- einen ersten Eingang ($I_i$) für ein Eingangs-Frequenzsignal ($FI_i$),
- einen ersten Ausgang ($O_i$) für ein Ausgangs-Frequenzsignal ($FO_i$), das dem ersten Eingang ($I_{i+1}$) der Zelle von höherem Rang (i+1) zuzuführen ist,
- einen zweiten Eingang ($SI_i$) für ein Freigabesignal des programmierten Modus,
- einen dritten Eingang ($P_i$) für ein Programmiersignal,
- einen zweiten Ausgang ($SO_i$) für ein Signal, das ausgehend von dem am zweiten Eingang ($SI_i$) empfangenen Freigabesignal erzeugt wird und als Freigabesignal dem zweiten Eingang ($SI_{i-1}$) der Zelle von niedrigerem Rang (i-1) zugeführt wird,

dadurch gekennzeichnet, daß mindestens eine Zelle einen zusätzlichen Eingang ($A_i$, $A_i'$) aufweist, der es erlaubt, den zweiten Ausgang ($SO_i$) der genannten Zelle auf ein aktives Niveau zu bringen, so daß diese Zelle in Bezug auf die Teilung deaktiviert wird.

2. Teilerschaltung nach Anspruch 1, dadurch gekennzeichnet, daß sie Mittel umfaßt zum:

- Deaktivieren der Zellen von Rang p bis p-q,
- Auswählen eines Ausgangssignals von der genannten Teilerschaltung, dessen Frequenz der Frequenz des Ausgangs-Frequenzsignals ($FO_{p-q-1}$) der Zelle des Rangs p-q-1 entspricht.

3. Teilerschaltung nach Anspruch 2, dadurch gekennzeichnet, daß sie zum Deaktivieren einer beliebigen Zelle des Rangs i Mittel umfaßt, die es erlauben, am zweiten Eingang ($SI_{i-1}$) der Zelle von niedrigerem Rang (i-1) ein kontinuierlich aktives Freigabesignal zu liefern.

4. Teilerschaltung nach Anspruch 3, dadurch gekennzeichnet, daß jede Zelle vom Rang i folgendes umfaßt:

- eine Stufe zur Teilung des Eingangs-Frequenzsignals ($FI_i$) der Zelle durch zwei, bestehend aus einer ersten (B1) und einer zweiten (B2) Kippschaltung vom Typ D, die durch das genannte Eingangs-Frequenzsignal ($FI_i$) zueinander entgegengesetzt getaktet werden, wobei der Ausgang der zweiten Kippschaltung (B2), der den Ausgang ($O_i$) der Zelle bildet, zum Dateneingang der ersten Kippschaltung (B1) zurückgeführt wird;
- eine "Schluck"-Stufe bestehend aus einer dritten (B3) und einer vierten (B4) Kippschaltung vom Typ D, wobei der Ausgang der vierten Kippschaltung (B4) es erlaubt, den Dateneingang der ersten Kippschaltung (B1) in Hinblick auf ein Verschlucken für eine Teilung des genannten Eingangs-Frequenzsignals ($Fi_i$) durch drei einzuschränken, wenn die Programmier- und Freigabesignale der Zelle aktiv sind;
- und eine dritte Kippschaltung (B3), die - wenn die Zelle deaktiviert werden kann - einen zusätzlichen Eingang ($A_i$) aufweist, der mit der Steuerelektrode eines Transistors (P) verbunden ist und die es erlaubt, wenn das empfangene Signal, das sogenannte Freigabesignal, nicht mehr aktiv ist, den Ausgang dieser dritten Kippschaltung (B3), welcher im übrigen den zweiten Ausgang ($SO_i$) der Zelle darstellt, auf einen kontinuierlich aktiven Pegel zu bringen.

5. Teilerschaltung nach Anspruch 4, dadurch gekennzeichnet, daß man das genannte Freigabesignal durch eine UND-Verknüpfung zwischen den Programmier- und den Freigabesignalen der Zelle von höherem Rang i+1 erhält.

6. Teilerschaltung nach einem der Ansprüche 2 bis 5, dadurch gekennzeichnet, daß sie Mittel umfaßt, um das am zweiten Ausgang ($SO_1$) der ersten Zelle gelieferte Signal als Ausgangssignal abzunehmen.

7. Teilerschaltung nach Anspruch 6, dadurch gekennzeichnet, daß sie Mittel umfaßt, um das zyklische Verhältnis des genannten Ausgangssignals zu erhöhen.

8. Frequenzsynthesizer, dadurch gekennzeichnet, daß er eine programmierbare Frequenzteilerschaltung gemäß einem der Ansprüche 1 bis 7 enthält.

9. Funktelefon, dessen Sendeschaltung oder dessen Empfangsschaltung einen Frequenzsynthesizer gemäß Anspruch 8 enthält.

**Claims**

1. A programmable frequency divider circuit comprising p cascade-connected frequency-dividing cells, each of these cells representing a division of rank i, all cells being switchable between a normal divide-by-two mode, and a programmed divide-by-three mode, a cell of arbitrary rank i comprising:

- a first input ($I_i$) for an input frequency signal ($FI_i$),
- a first output ($O_i$) for an output frequency signal

$(FO_i)$ to be applied to the first input $(I_{i+1})$ of the cell of higher rank (i+1),

- a second input $(SI_i)$ for an enable signal for the programmed mode,
- a third input $(P_i)$ for a programming signal,
- a second output $(SO_i)$ for a signal generated in response to the enable signal received through its second input $(SI_i)$ and applied to the second input $(SI_{i-1})$ of the cell of lower rank (i-1) as an enable signal, characterized in that at least one cell has an additional input $(A_i, A_i')$ that makes it possible to put the second output $(SO_i)$ of said cell to an active level so as to disable said cell with respect to the division.

2. A divider circuit as claimed in Claim 1, characterized in that a divider circuit comprises means for:

- disabling the cells from rank p to p-q,
- selecting an output signal of said divider circuit which has the same frequency as the output frequency signal $(FO_{p-q-1})$ of the cell of rank p-q-1.

3. A divider circuit as claimed in Claim 2, characterized in that for disabling an arbitrary cell of rank i, the divider circuit comprises means allowing to supply a continuously active enable signal to the second input $(SI_{i-1})$ of the cell of lower rank (i-1).

4. A divider circuit as claimed in Claim 3, characterized in that each cell of rank i comprises:

- a divide-by-two divider stage of the input frequency signal $(FI_i)$ of the cell, formed by a first (B1) and a second (B2) D-type flip-flop inversely timed relative to each other by said input frequency signal $(FI_i)$, the output of the second flip-flop (B2), which forms the output $(O_i)$ of the cell, being looped back to the data input of the first flip-flop (B1),
- a swallow stage formed by a third (B3) and a fourth (B4) D-type flip-flop, the output of the fourth flip-flop (B4) making it possible to constrain the data input of the first flip-flop (B1), with a view to a swallowing, for a division by three of said input frequency signal $(FI_i)$, when the programming and enabling signals of the cell are active,
- and the third flip-flop (B3) having, when the cell may be disabled, an additional input $(A_i)$ coupled to the control electrode of a transistor (P) and which allows, when the signal it receives called activating signal is no longer active, to bring the output of this third flip-flop (B3), which furthermore forms the second output $(SO_i)$ of the cell, to a continuously active level.

5. A divider circuit as claimed in Claim 4, characterized in that said enabling signal is obtained from a logical "AND" operation between the programming and enabling signals of the cell of a higher rank i+1.

6. A divider circuit as claimed in one of the Claims 2 to 5, characterized in that the divider circuit comprises means for tapping the signal supplied on the second output $(SO_1)$ of the first cell as an output signal.

7. A divider circuit as claimed in Claim 6, characterized in that the divider circuit comprises means for increasing the duty cycle of said output signal.

8. A frequency synthesizer, characterized in that the divider circuit comprises a programmable frequency divider circuit as claimed in one of the Claims 1 to 7.

9. A radiotelephone of which either the transmitter circuit or the receiver circuit comprises a frequency synthesizer as claimed in Claim 8.

FIG.1

FIG.4

FI$_i$

Q1

FO$_i$

P$_i$

## FIG.2

## FIG.5

FIG.3

FIG.7

FIG.6

FIG.8

EP 0 682 411 B1

FIG.9

PGM

FIG.10